# EUROPEAN PATENT SPECIFICATION

(11) **EP 3 331 334 B1**
(45) Date of publication and mention of the grant of the patent: **19.05.2021**
(21) Application number: 16201446.8
(22) Date of filing: 30.11.2016
(51) Int. Cl.: H05K 7/14

(54) **MODULE ARRANGEMENT WITH RESETTING MECHANISM**
MODULANORDNUNG MIT RÜCKSTELLUNGSMECHANISMUS
AGENCEMENT DE MODULE AVEC MÉCANISME DE RÉARMEMENT

(43) Date of publication of application: 06.06.2018
(73) Proprietor: TE Connectivity Germany GmbH, 64625 Bensheim (DE); ABB Schweiz AG, 5400 Baden (CH)
(72) Inventor: Hess, Karl-Heinz, 64646 Heppenheim (DE); Herrmann, Andreas, 64560 Riedstadt (DE); Aboulkassem, Mohamed, 64347 Griesheim (DE); Hertzberg, Thomas, 64289 Darmstadt (DE); Kraemer, Peter, 64689 Grasellenbach (DE); Symantzik, Andreas, 64372 Ober-Ramstadt (DE); Ofenloch, Markus, 68642 Bürstadt (DE); Zimmer, Frank, 64283 Darmstadt (DE); Keul, Thomas, 63579 Freigericht (DE); Hammarstrand, Erik Wilhelm H., 72355 Vaesterås (SE); Hagemann, Michael, 64295 Darmstadt (DE)
(74) Representative: Grünecker Patent- und Rechtsanwälte PartG mbB

(56) References cited:
- EP-A1- 2 829 927
- DE-U1- 29 906 583
- US-A1- 2015 017 842
- US-B1- 6 196 881

## Description

The invention relates to a module arrangement for a modular field device connection unit, the arrangement comprising a frame module with at least one interface receptacle for receiving at least one interchangeable interface module, and at least one interface module, which is insertable into the at least one interface receptacle along a module insertion path, wherein the at least one interface module is provided with at least one cartridge receptacle for receiving at least one cartridge member, and wherein the at least one interface module is provided with at least one movable coding element, which is moveable from a neutral position into at least one coding position by insertion of a cartridge member into the cartridge receptacle. The invention further relates to a modular field device connection unit and to a method for coding and resetting the coding of at least one interface module of a modular field device connection unit, wherein at least one movable coding element is moved from a neutral position into at least one coding position by inserting a cartridge member into the at least one interface module along a module insertion path, and wherein the cartridge member is removed from the at least one interface module.

Module arrangements for modular field device connection units, modular field device connection units and methods as described above are used for connecting field devices to other components, for example to a field bus system. A module arrangement with an interface module which is provided with moveable coding elements is known from EP 2 829 927 A1 of one of the applicant's. In this document, wedge-shaped unmoveable coding elements are adapted to move moveable coding elements on a module into coding positions during insertion of a cartridge member. Once arranged in coding positions, the moveable coding elements prevent insertion of cartridge members with differently arranged unmoveable coding elements.

The solution described above is useful for a coding of interface modules to prevent the insertion of a wrong cartridge member into a cartridge receptacle. A drawback of this solution is, however, that it does not provide a solution for moving the at least one movable coding element back into the neutral position. If this task is performed manually, then it is complicated and time-consuming.

It is therefore an object of the invention to facilitate the resetting of at least one moveable coding element into a neutral position.

This object is reached for the module arrangement mentioned in the beginning in that the at least one module arrangement is provided with at least one resetting mechanism for resetting the at least one movable coding element into the neutral position by insertion of the at least one interface module into the at least one interface receptacle and/or removal out of it, respectively the resetting mechanism comprising at least one trigger element, the trigger element at least partially protruding into the at least one module insertion path.

For the method as mentioned in the beginning, this object is reached in that by insertion of the at least one interface module into at least one interface receptacle of a frame module of the modular field device connection unit and/or removal of the at least one interface module thereof, the at least one movable coding element interacts with at least one resetting apparatus of the at least one frame module, resetting the at least one movable coding element from the at least one coding position to the neutral position with at least one trigger element which protrudes into the module insertion path. For the modular field device connection unit as mentioned in the beginning, the object is reached in that the unit comprises at least one module arrangement according to the invention.

The solution according to the invention allows the resetting of at least one moveable coding element during insertion of the interface module into the frame module and/or removal of the interface module thereof. In particular, the solution allows automatically resetting the coding of at least one moveable coding element during insertion or removal of the interface module. The resetting can be useful during insertion of an interface module into a frame module for setting up a new module arrangement in order to start with at least one interface module having moveable coding elements in the neutral position. Starting from this, the moveable coding elements can be coded, that means moved into at least one coding position by insertion of a cartridge member. The resetting during removal of the at least one interface module from a frame module can be useful for example in the case that an interface module is removed in order to be used in a different arrangement or stored for further uses. The module insertion path may thereby be seen as a channel along which at least parts of the interface module move during insertion. The path can be defined by housing parts of the frame module, by guiding members of the interface receptacle or other means.

The solution according to the invention allows the resetting without the need for manually moving back the at least one moveable coding element into a neutral position. Further, the solution allows the resetting without the need for extra tools. Consequently, the solution according to the invention, saves time and costs. Another advantage of the invention is that the resetting can be pre-formed without the need to remove cables which can be connected to the interface module, for example cables for connecting field devices.

In the following, further improvements of the invention are described. The additional improvements may be combined independently of each other, depending on whether a particular advantage of a particular improvement is needed in a specific application.

According to a first advantageous improvement, the at least one trigger element may at least partially protrude into an insertion path of the at least one moveable coding element, in particular in the coding position of the at least one movable coding element. The insertion path of the at least one moveable coding element is part of the module insertion path. Thereby, the at least one trigger element may directly interact with the moveable coding element, for example by pushing the at least one moveable coding element from the at least one coding position into the neutral position. In particular, the at least one moveable coding element may be pivotable between the neutral position and the at least one coding position. The at least one trigger element may then interact with the at least one moveable coding element such that it is pivoted back from a coding position into the neutral position.

In a preferred embodiment, the at least one trigger element collides with at least one moveable coding element during insertion and/or removal of the at least one interface module from the frame module only when the moveable coding element is in a coding position. Consequently, the at least one trigger element does not collide with a moveable coding element when said coding element is arranged in the neutral position.

The at least one resetting mechanism may comprise at least one pair of trigger elements, the two trigger elements of the at least one pair being arranged opposite each other across the module insertion path. This may be advantageous for the case that the at least one moveable coding element is moveable between two coding positions and a neutral position, wherein the neutral position is arranged between the two coding positions. In the case of two oppositely arranged trigger elements, the moveable coding element may always interact with one of the trigger element, independently of the coding position in which the moveable coding element is arranged.

For smoothly guiding and moving the at least one moveable coding element from the at least one coding position into the neutral position during insertion and/or removal of the interface module into or from the frame module, the at least one trigger element may comprise at least one, in particular sloped, guiding surface on the at least one frame module for moving the at least one moveable coding element from the at least one coding position into the neutral position.

In particular, the at least one guiding surface may be inclined with respect to a direction of insertion of the interface module into the frame module. In order to allow the resetting of a moveable coding element during insertion and removal of the interface module into the frame module or out of it, the at least one trigger element may comprise two guiding surfaces which are arranged opposite to each other along the module insertion path. Thereby, the at least one trigger element may have an overall triangular shape which protrudes with two edges and consequently one vertex into the insertion path of the moveable coding elements.

Preferably, the at least one trigger element is arranged on the frame module. More preferably, the at least one trigger element is formed monolithically with the frame module, for example with a housing part of the frame module.

According to another advantageous embodiment, the at least one interface module may be provided with at least one deflectable pusher member and the frame module may be provided with at least one trigger element, the trigger element protruding into an insertion path of the at least one pusher member. The at least one deflectable pusher member may be used for transmitting a force from the at least one trigger element to the at least one moveable coding element.

In particular, the moveable coding element can at least partially be arranged between two deflectable pusher members which are arranged opposite to each other across the module insertion path. The at least one deflectable pusher member may be arranged on the interface module such that it at least partially covers the at least one moveable coding element.

For easily moving back a once deflected pusher member, the at least one deflectable pusher member may be elastically deflectable towards the at least one moveable coding element.

In order to achieve a simple and stable structure, the at least one pusher element may be monolithically formed with the interface module. For example, the at least one pusher member may be connected with the remaining interface module via a non-deflectable base and extend from there to a deflectable free end.

The neutral position and the at least one coding position are preferably stable positions of the at least one moveable coding element with respect to the remaining interface module. This may help in retaining a position when a force from a cartridge member or the resetting mechanism is not applied on a moveable coding element. In this context, being stable means stable as long as none of the aforementioned members interact with the at least one moveable coding element. For example, the at least one moveable coding element can preferably not be moved due to gravitational force.

Preferably, the at least one moveable coding element and the remaining interface module form a bi-stable system if one coding position and a neutral position are possible. If two coding positions and one neutral position are possible, the system may be a tri-stable system.

For easily achieving stability of the at least one moveable coding element in a defined position, the at least one moveable coding element may be kept in at least one position by frictional force.

For being movable, the at least one movable coding element may in particular be mounted on a pin in a movable manner. The pin can be connected to the interface module in a non-movable manner. At least one movable coding element may be provided with a through hole through which the pin may extend in an assembled state. The through hole may be provided in a mounting section of the at least one movable coding element. A frictional force between the at least one pin and the at least one movable coding element may keep the movable coding element in a desired position.

In particular, the at least one movable coding element may be mounted on a pin such that it is rotatable or, in other words pivotable, with respect to the remaining interface module. Thereby, the at least one movable coding element is rotatable around an axis of rotation. In particular, the at least one pin may be arranged along the axis of rotation.

Alternatively or additionally to providing a stable position by frictional force, the at least one movable coding element may be kept in at least one position by at least one form fit arrangement. The at least one form fit arrangement may in particular be formed as a ratchet arrangement with at least one nose on either the movable coding element or the interface module, and at least two recesses for the at least one nose provided on the other element. The nose can be adapted for being seated in the recesses which may each correspond to a certain position.

The at least one movable coding element may comprise at least one coding section for interaction with at least one complementary coding element of the cartridge member, and at least one resetting section for interacting with the at least one resetting mechanism at least in the coding position. Thereby, a simple structure can be achieved. If the at least one movable coding element is held rotatable or pivotable around an axis of rotation, then the coding section and the resetting section are preferably arranged on opposite sides of the axis of rotation.

For easily interacting with the at least one trigger element, the at least one resetting mechanism may comprise at least one extension, in particular a lever, on the at least one movable coding element, the extension providing the at least one resetting section.

Preferably, the at least one extension longitudinally extends from the remaining movable coding element. More preferably, both, the coding section and the resetting section comprise an overall longitudinal shape and extend along a common longitudinal axis in two opposite directions from a mounting section of the movable coding element.

In order to further facilitate the interaction with the at least one trigger element, the at least one extension may be provided with at least one arm for interacting with the at least one trigger element, at least in the coding position, the arm extending basically perpendicular to a longitudinal direction of the extension.

The modular field device connection unit according to the invention may further be improved in that the modular field device connection unit further comprises at least one cartridge member with at least one unmovable coding element with at least one sloped surface which is adapted to move at least one movable coding element of the at least one interface module from its neutral position into at least one coding position by inserting the at least one cartridge member into the at least one interface module. The cartridge member may be used for coding the at least one movable coding element and for providing further, in particular electronic, components for the module arrangement. The at least one sloped surface may be an inclined surface.

In the following, the invention and its improvements are described in greater details using exemplary embodiments and with reference to the drawings. As described above, the various features shown in the embodiments may be used independently of each other in specific applications.

In the following figures, elements having the same function and/or the same structure will be referenced by the same reference signs.
- Fig. 1: shows a cut view through an interface module according to the invention;
- Fig. 2: shows a cut view of an interface module in the region of the moveable coding elements during insertion of a cartridge member;
- Fig. 3: shows the insertion of a cartridge member into the interface module of Fig. 2 and the coding process;
- Fig. 4: shows a resetting process of a module arrangement according to the invention;
- Fig. 5: shows a cross-sectional view of a plurality of moveable coding elements arranged on a pin;
- Fig. 6: shows a perspective schematic view of another embodiment of an interface module according to the invention; and
- Fig. 7: shows a cross-sectional view of the module of Fig. 6 in the region of the moveable coding elements.

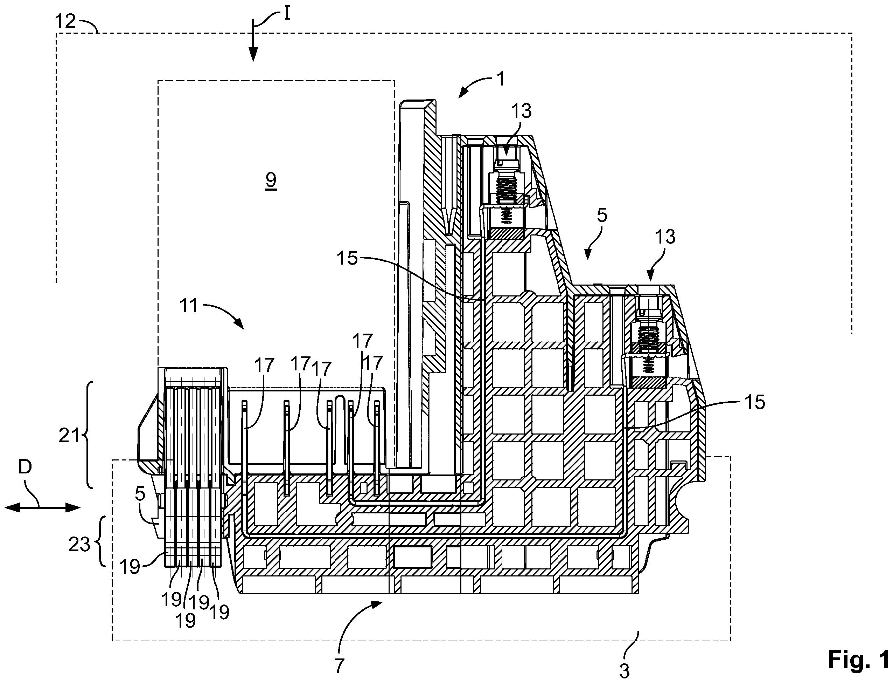

In the following, an interface module 5 according to the invention and its function in a module arrangement 1 according to the invention are briefly described with respect to Fig. 1. Coding and resetting are described further below with respect to the following figures.

The module arrangement 1 according to the invention comprises a frame module 3 which is indicated by the slash-dot line in the lower portion of Fig. 1. The arrangement 1 further comprises at least one interchangeable interface module 5 which is insertable into an interface receptacle 7 of the frame module 3. The module arrangement 1 and at least one cartridge member 9, which is insertable into a cartridge receptacle 11 of the interface module 5 may together be part of a modular field device connection unit 12 which is indicated by a dashed line in Fig. 1. The cartridge member 9 is indicated by another dashed line in Fig. 1.

The module arrangement 1 may comprise a plurality of interface receptacles 7 in the frame module 3, a plurality of interface modules 5 and may further comprise none or any number of cartridge members 9. However, for the sake of clarity and brevity, the structure and the function of the individual features are described with respect to a single interface module 5 in the following.

The module arrangement 1 can be used for connecting field devices (not shown) to a field bus system (not shown). The field bus system can be connected to the frame module 3 such that an interface module 5 may also be electrically connected to the field bus. For example, the frame module 3 and/or the interface module 5 may be connected to at least one DIN rail of a field bus system.

For connecting field devices to the module arrangement 1, the interface module comprises field device connection elements 13. The field device connection elements 13 are electrically connected via conductors 15 to electric contacts 17. The electric contacts 17 are arranged in the cartridge receptacle 11 and are adapted for being electrically contacted to complementary contacts (not shown) in the cartridge member 9. In this way, the output of the field device connection elements 13 can be controlled via an inserted cartridge member 9. Each cartridge member 9 may just by way of example comprise electric circuits, electric components or further connection elements for additional connections to other components.

The cartridge member 9 is insertable along an insertion direction I into the cartridge receptacle 11. Preferably, the interface module 5 is insertable along the same direction I into the interface receptacle 7. Therefore, the insertion direction I also defines the insertion direction of the interface module 5 into the frame module 3 and the direction I is used for both components hereafter.

The interface module 5 is provided with a plurality of moveable coding elements 19. The moveable coding elements 19 are preferably arranged adjacent to each other along a depth direction D of the interface module 5. Each moveable coding element 19 comprises a coding section 21 and a resetting section 23. The moveable coding elements 19 basically extend parallel with the insertion direction I, wherein the coding section 21 is aligned towards the cartridge receptacle 11 and the resetting section 23 is aligned towards the interface receptacle 7. The coding section 21 of each moveable coding element 19 is intended for interacting with the cartridge member 9 for being coded, whereas the resetting section 23 is intended for interacting with the resetting mechanism (not shown yet) of the module arrangement 1.

The moveable coding elements 19 at least partially protrude out of a housing 25 of the interface module 5 along the insertion direction I such that interaction with a resetting mechanism, which is preferably at least partially arranged in the frame module 3, is possible.

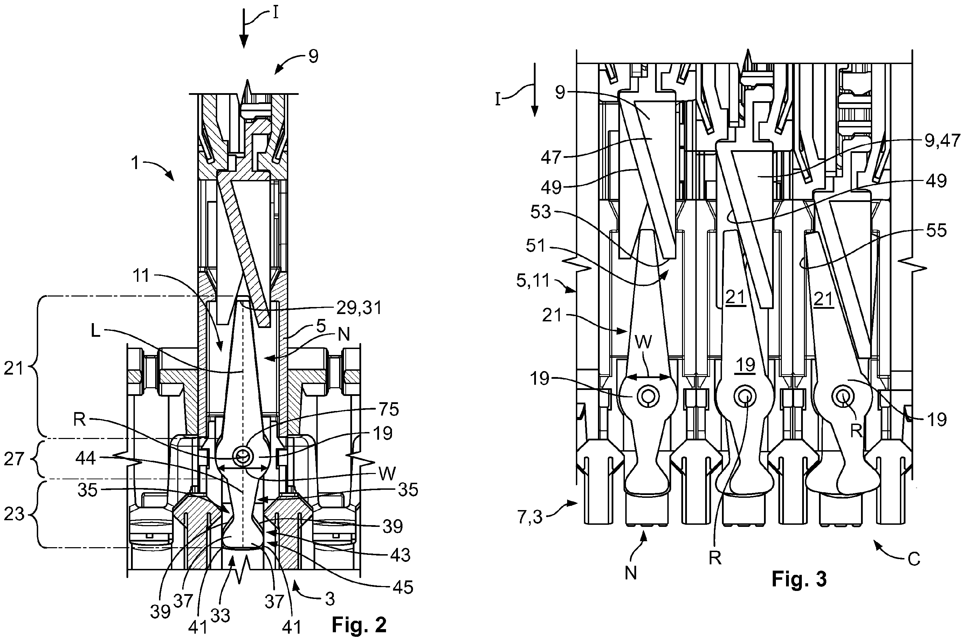

In the following, the structure of a preferred embodiment of a moveably coding element 19 is described with respect to Fig. 2. Later on, the coding function during insertion of a cartridge member 9 into the cartridge receptacle 11 is described with respect to Fig. 3.

Fig. 2 shows a cutout view of an interface module 5 with view on one moveable coding element 19, a part of a cartridge member 9 in a not fully inserted state in the cartridge receptacle 11, and parts of the frame module 3. The interface module 5 is thereby identical to the one as shown in Fig. 1. Fig. 2 shows the module arrangement 1 in a view which is rotated around 90° around the insertion direction I with respect to the view of Fig. 1.

The moveable coding element 19 has an overall longitudinal shape which extends a longitudinal axis L of the coding element 19. The longitudinal axis L is basically parallel with the insertion direction I when the moveable coding element 19 is in the neutral position N as shown in Fig. 2. Preferably, the moveable coding element 19 is formed mirror-symmetrically with respect to the longitudinal axis L.

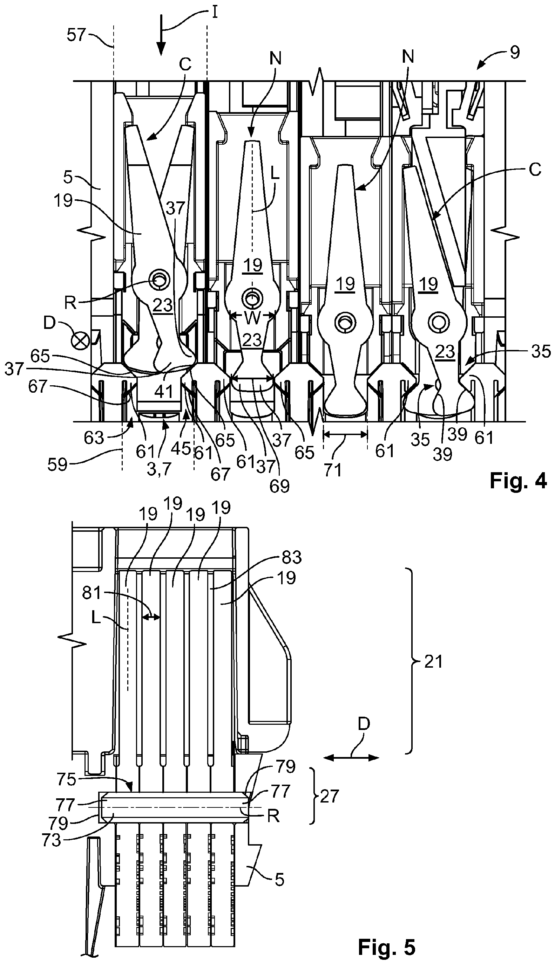

The moveable coding element 19 comprises a mounting section 27 at which it is mounted in a moveable manner to the interface module 5. The mounting section 27 is arranged between the coding section 21 and the resetting section 23 along the longitudinal axis L. In other words, the mounting section 27 separates the coding section 21 and the resetting section 23. In the mounting section 27, the moveable coding element 19 is held rotatably around an axis of rotation R. Said axis of rotation R is arranged perpendicular to the longitudinal axis L. Details of the mounting of the moveable coding elements 19 to the interface module 5 are later described with respect to Fig. 5.

In the coding section 21, the moveable coding element 19 tapers from the mounting section 27 towards a free end 29. In the free end 29, the moveable coding element 19 is provided with a stop surface 31. The stop surface 31 basically extends perpendicular to the longitudinal axis L. However, this shape may vary. For example, the stop surface 31 may also have an overall convex shape such that a portion of the stop surface 31 is perpendicular to the insertion direction I when the moveable coding element 19 is in one of the coding positions (not shown yet).

The moveable coding element 19 comprises a through hole 75 in the mounting section 27 for mounting the moveable coding element 19 in a rotatable manner. In order to maintain the stability of the moveable coding element 19, the width of the moveable coding element 19 which is measured along a width direction W is highest in the mounting section 27. The width direction W extends perpendicular to the longitudinal axis L. As already mentioned above with respect to the tapering of the moveable coding element 19 in the coding section 21, the width measured in the width direction W decreases from the mounting section towards the free end 29.

In the resetting section 23, the width of the moveable coding element 19 initially decreases starting from the mounting section 27 towards a free end 33 of the moveable coding element 19, and, afterwards increases again, in such a way that two recesses 35 are formed in the moveable coding element 19 in the resetting section 23 which lie opposite to each other across the longitudinal axis L. The recesses 35 are intended for not interfering with a resetting mechanism during coding of the element 19 when the interface module 5 is inserted in the frame module 3 and intended for being used.

The width of the moveable coding element 19 increases towards its free end 33 by two arms 37 which extend from the remaining moveable coding element 19 in the width direction W on both sides of the longitudinal axis L. Each arm 37 comprises a proximal sloped surface 39 with which the width of the moveable contact element 19 decreases from a region in which the arm has its largest extension along the width direction W in the direction of the mounting section 27.

Further, each arm is provided with a distal sloped surface 41 with which the width of the moveable coding element 19 decreases from the above-mentioned region where the arm 37 has its largest extension in the width direction W towards the free end 33. With both arms 37, each comprising a proximal sloped surface 39 and a distal sloped surface 41, the region of the resetting section 23 which is provided with the arms 37 has an overall anvil-like shape.

In order to allow smooth insertion of the interface module 5 into the frame module 3 and removal thereof, the transition between a proximal sloped surface 39 and a distal sloped surface 41 is preferably smooth such that curved contours are formed.

The arms 37 are arranged on an extension 43 of the moveable coding element 19. The extension 43 basically forms the resetting section 23. Thereby, the arms are arranged on a distal end of the extension 43 which is arranged closer to the free end 33 than to the mounting section 27. The extension 43 may work as a lever for the moveable coding element 19. The extension 43 extends longitudinally along a longitudinal direction 44 which is preferably parallel with the longitudinal direction L of the movable coding element 19.

A force which acts perpendicular to the longitudinal axis L on the extension 43 will result in a rotational movement of the moveable coding element 19 around the axis of rotation R and, consequently, in pivoting of the coding section 21. The extension 43 together with the arms 37 and their sloped surfaces 39 and 41 are a part of the resetting mechanism 45, which is described in detail with respect to Fig. 4 later on.

In the following, the coding process of a moveable coding element 19 is described with respect to Fig. 3. In Fig. 3, three different positions of the moveable coding element are shown. Fig.3 shows an frame module 3 with a plurality of interface receptacle 7, wherein an interface module 5 is inserted in each interface receptacle 7. Into each interface module 5 in Fig. 3, a cartridge member 9 is inserted, wherein each cartridge member 9 is shown in a different state of insertion. Since the interface modules 5 are identical, the insertion process is described in the following by using each pair of interface module 5 and cartridge member 9 as representatives of a certain state of insertion.

Starting from the left, the first moveable coding element 19 is in the neutral position as already shown in Fig. 2. The moveable coding element 19 in the middle is shown in an intermediate state during movement from the neutral position into the coding position C, which is shown on the right side of Fig. 3.

Starting from the left in the neutral position N, the interface module 5 is seated in the interface receptacle 7 of the frame module 3. The coding section 21 extends parallel to the insertion direction I of a cartridge member 9.

The cartridge member 9 is provided with at least one, preferably a plurality of unmovable coding elements 47. Each unmovable coding element 47 is provided with an inclined surface 49 which is inclined with respect to the insertion direction I. Each unmovable coding element 47 has an overall wedge-like shape. A free end 51 of each unmovable coding element 47 is provided with a stop surface 53, which basically extends perpendicular to the insertion direction I.

Preferably, the cartridge member 9 is provided with the same number of unmovable coding elements 47 as the number of movable coding elements 19 provided on the interface module 5. Each free end 51 of an unmovable coding element 47 is arranged such that it takes a position beside the free end 29 of the moveable coding element 19 in the beginning of the insertion of the cartridge member 9 in the case that the moveable coding element 19 is in the neutral position N. In this situation, which is shown on the left in Fig. 3, the inclined surface 49 of the unmovable coding element 47 overlaps with at least the free end 29 of the moveable coding element 19 seen in the insertion direction I.

Further insertion of the cartridge member 9 into the cartridge receptacle 11 of the interface module 5 results in moving the moveable coding element 19 out of the neutral position N. This situation is shown in the middle of Fig. 3. The unmovable coding element 47 is pushed along the moveable coding element 19 such that the inclined surface 47 pushes the coding section 21 out of the neutral position N. The moveable coding element 19 thereby rotates around the axis of rotation R.

When the cartridge member 9 is fully inserted in the cartridge receptacle 11, the unmovable coding element 47 has moved the coding section 21 of the moveable coding element 19 such that the moveable coding element 19 is in the coding position C. This situation is shown on the right side of Fig. 3. In the coding position C, the coding section 21 abuts an inner wall 55 of the interface module 5.

The coding position C is, as the neutral position N, a stable position which means that if a cartridge member 9 and/or a resetting mechanism 45 are not exceeding force on the moveable coding element 19, said element 19 will remain in its position. Since preferably two different coding positions C are possible for a single moveable coding element 19, the moveable coding element 19 may be a tri-stable system.

After removal of the cartridge member 9, the coding elements 19 remain in their coding position C. If it is intended to insert a cartridge member 9 again, then only a cartridge member 9 which comprises similarly arranged unmovable coding elements 47 is allowed to be inserted in the cartridge receptacle 11. If, for example, a cartridge member 9 is to be inserted which has differently arranged unmovable coding elements 47, then the stop surfaces 53 of the differently arranged unmovable coding elements 47 will abut the stop surfaces 31 of the moveable coding elements 19 during or before insertion of the cartridge member 9 into the cartridge receptacle 11.

In the following, a resetting mechanism 45 according to the invention and its functions is described with respect to Fig. 4. Thereby, the process of resetting the movable coding elements 19 of an interface module 5 is described during insertion of an interface module 5 into the interface receptacle 7 of a frame module 3. This is shown again from left to right in Fig. 4. The interface module 5 shown in Fig. 4 is identical to the interface module 5 as shown in Fig. 3 and is arranged in the same coding position C as on the right side of Fig. 3.

In the following, the structure of the resetting mechanism 45 is described. Afterwards, the function of the resetting mechanism 45 is described. For the sake of clarity, only the structure of a single resetting mechanism 45 and a single interface module 5 and the related components is described.

The interface module 5 is insertable along a module insertion path 57 into the interface receptacle 7 of the frame module 3. The module insertion path 57 can be defined by guiding elements (not shown) on the frame module 3. Preferably, the module insertion path 57 extends parallel to the insertion direction I of the cartridge member 9 into the interface module 5 which is preferably also the direction of insertion I of an interface module 5 into the interface receptacle 7.

A portion of the module insertion path 57 through which the moveable coding element 19 is moved during insertion of the interface module 5 into the frame module 3 is formed by an insertion path 59 of the moveable coding element 19.

The resetting mechanism 45 comprises, in addition to the arms 37 on the moveable coding element 19, two trigger elements 61 which are formed on the frame module 3 and which protrude into the insertion path 59 of the movable coding element 19 and therefore also in the module insertion path 57.

Preferably, the trigger elements 61 are monolithically formed with the frame module 3. The two trigger elements 61 are arranged opposite each other across the module insertion path 57 and arranged at the same height along the insertion direction I. The two trigger elements 61 form a pair of trigger elements 63.

Preferably, the module arrangement 1 comprises one pair 63 for at least one moveable coding element 19. More preferably, the module arrangement 1 comprises one pair 63 of trigger elements 61 for the plurality of moveable coding element 19. Thereby, each trigger element 61 may extend along the depth direction D which is perpendicular to the insertion direction I and to the width direction W of a moveable coding element 19 in the neutral position N. In other words, the depth direction D is the direction in which the moveable coding elements 19 of an interface module 5 are arranged adjacent to each other.

Each trigger element 61 preferably comprises two guiding surfaces 65 and 67. The guiding surface 65 extends in the insertion direction I and towards the opposite trigger element 61, whereas the guiding surface 67 extends against the insertion direction I and towards the opposite trigger element 61. Preferably, each guiding surface 65 and 67 is inclined at an angle between 30 and 60 degrees with respect to the insertion direction I.

In the following, the resetting function of the resetting mechanism 45 is briefly described with respect to Fig. 4. Also here, the function is described with respect to a single moveable contact element 19 only for the sake of brevity and clarity. However, the same function can be applied to the plurality of moveable coding elements 19 of the interface module 5 and is preferably applied to all moveable coding elements 19 at the same time during resetting.

As already mentioned above, the left side of Fig. 4 shows a moveable coding element 19 in the coding position C. During insertion of the interface module 5 into the interface receptacle 7, the resetting section 23 of the moveable coding element 19 abuts one of the trigger elements 61.

Since the resetting mechanism 45 is provided with two trigger elements 61, it does not matter, to which of the two coding positions C the moveable coding element 19 is pivoted since the resetting section 23 will always overlap with one of the trigger elements 61 in the insertion direction I. Since the trigger elements 61 protrude into the insertion path 59, the resetting section 23 collides with one of the trigger elements 61.

In Fig. 4, the trigger elements 61 on the right side collide with the resetting section 23 of the moveable coding element 19. Thereby, contact is made between the distal sloped surface 41 of the arm 37 and the guiding surface 65 of the trigger element 61. During further insertion of the interface module 5 into the interface receptacle 7, the arm 37 slides along the guiding surface 65 such that a force is applied on the resetting section 23 causing said section to move closer to the centre of the insertion path 59. Thereby, the moveable coding element 19 rotates around the axis of rotation R causing the movable coding element 19 to move back towards the neutral position N.

In the next stage, which is shown in the second part of Fig. 4, starting from the left, the arms 37 of the moveable coding element 19 in the resetting section 23 are arranged between the two opposite trigger elements 61. Thereby, the maximum width 69 of the moveable coding element 19 in the resetting section 23, which is measured along the width direction W, is identical or slightly lower than the minimal distance 71 between the two opposite trigger elements 61. Insertion of the resetting section 23, at least the region with the maximum width 69 between the two opposite trigger elements 61 guarantees that the resetting section 23 is centered between the two trigger elements 61 such that the longitudinal axis L of the moveable coding element 19 is arranged parallel to the insertion direction I and thereby situated in the neutral position N. Thus, the moveable coding element 19 is reset.

In the third part of Fig. 4, starting from the left, the interface module 5 is fully inserted in the frame module 3. Since the moveable coding element 19 is not moveable without a force being applied on it from a resetting mechanism 45 or a cartridge member 9, the moveable coding element 19 maintains the neutral position N.

In the following, the moveable coding element 19 can be used for coding again by inserting a cartridge member 9. This is shown in the right part of Fig. 4. The coding can be performed as previously described with respect to Fig. 3. In the coding position C, the trigger element 61, which comes closest to the resetting section 23 of the moveable coding element 19 can be received in the recess 35 such that it will not interact with the resetting section 23 and will not apply a force on the moveable coding element 19 which would cause said element 19 to move back to the neutral position N.

In the coding position C, one of the proximal sloped surfaces 39 can abut one of the trigger elements 61 and can be in direct contact with one of the guiding surfaces 67. This abutment can help to support the movable coding element 19 when one attempts to insert a differently coded cartridge member 9. The abutment helps to keep the movable coding element 19 in the coding position C.

It should also be noted that the moveable coding element 19 can also be moved back from the coding position C to the neutral position N during removal of the interface module 5 from the frame module 3. In this case, one of the proximal sloped surfaces 39 of the moveable coding element 19 will collide with one of the guiding surfaces 67 causing the moveable coding element 19 to move back into the neutral position N.

Fig. 5 shows a plurality of moveable coding elements 19 in a cut view perpendicular to the longitudinal axis L and perpendicular to the depth direction D.

As already mentioned, the moveable coding elements 19 are arranged such that they are arranged adjacent to each other along the depth direction D.

In the mounting section 27, each moveable coding element 19 is rotatably mounted on a pin 73 which extends along the axis of rotation R. The pin penetrates through each moveable coding element 19 in the mounting section 27. Therefore, each moveable coding element 19 is provided with a through-hole 75 which extends to the moveable coding element 19 along the depth direction D such that the pin 73 can be inserted in said through-hole 75. The pin is preferably kept in the interface module 5 by press-fit wherein the opposite ends of ends 77 of the pin 73 are pressed in complementary openings 79 in the interface module 5. The moveable coding elements 19 are rotatably mounted on the pin 73.

Preferably, the moveable coding elements 19 are mounted on the pin 73 such that they can be rotated around the axis of rotation R only when a predefined force is exceeded. Thus, the moveable coding elements 19 cannot be moved by gravitational force or typical low vibrations which may occur during transport.

The frictional force between the moveable coding elements 19 in the mounting section 27 and the pin 73 allows the moveable coding elements 19 to remain in one of the coding positions C or the neutral position N. In the coding section 21

The moveable coding element 19 may have a thickness 81 which is lower than a thickness in the mounting section 27. Due to the reduced thickness in the coding section 21, gaps 83 are formed between two adjacent moveable coding elements 19 in the region of the coding sections 21. These gaps 83 prevent interaction of two adjacent moveable coding elements 19 with each other.

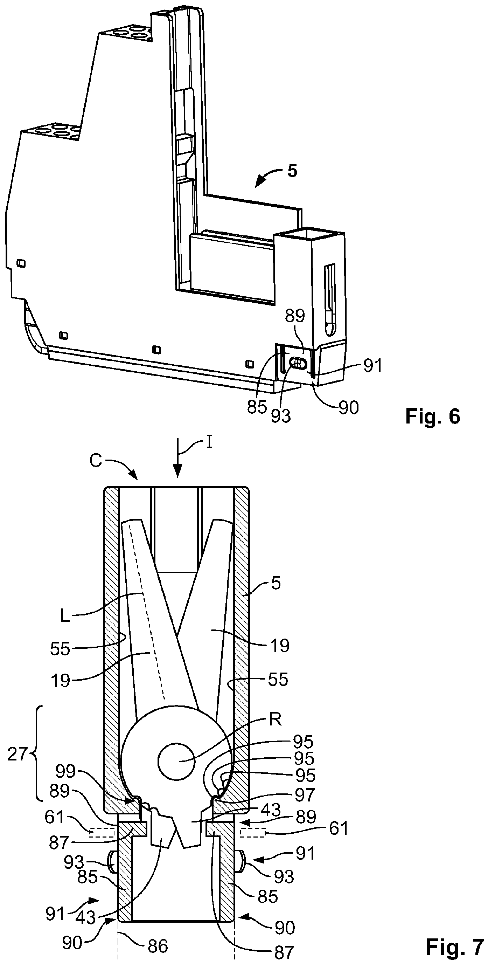

In the following, a second preferred embodiment of an interface module 5 according to the invention is described with respect to Figs. 6 and 7.

In the embodiment as described above with respect to Figs. 1 to 5, at least the resetting sections 23 of the moveable coding elements 19 protrude out of the interface module 5. This may be useful for easily resetting the coding elements 19.

However, if for example protection of the moveable coding elements 19 is sought, then the second embodiment of the interface module may be helpful. In the second embodiment of the interface module 5, as shown in Figs. 6 and 7, each moveable coding element 19 is provided with an extension 43 that is not provided with arms 37. However, also the extensions 43 of the second embodiment may alternatively be provided with said arms 37.

The interface module 5 is provided with two elastically deflectable pusher members 85. The pusher members 85 are preferably formed monolithically with the interface module 5. The pusher members 85 are arranged opposite each other with the extensions 43 of the resetting sections 23 of the moveable coding elements 19 between them. The pusher members 85 are elastically deflectable towards each other.

If a moveable coding element 19 is arranged in a coding position C, as shown in Figure 7, then deflecting the pusher members 85 towards each other will result in resetting the moveable coding element 19 into the neutral position N again. During deflection of both pusher members 85, the space between both pusher members 85 narrows such that the extension 43 will collide with at least one of the pusher members 85 and move into the centre between both pusher members 85.

When the interface module 5 is inserted along the module insertion path 57, the pusher members 85 are inserted along an insertion path 86 which is part of the module insertion path 57.

Both pusher members 85 are preferably formed with protrusions 87 which protrude towards each other at the height of the extensions 43. When both pusher members 85 are deflected towards each other, then the protrusions 87 may collide with the extensions 43 to bring the moveable coding elements 19 back into the neutral position.

The protrusions 87 are arranged on elastically deflectable free ends 89 of the pusher members 85 which are arranged on opposite sides of the basis 90 of the pusher elements 85 at which the pusher elements 85 are unmovably connected with the remaining interface module 5. Each basis 90 is arranged opposite the protrusions 87 seen parallel with the insertion direction I.

On outer sides 91 of the pusher members 85 facing away from each other, the pusher members 85 are provided with outer protrusions 93. Thereby, each outer side 91 is provided with one outer protrusion 93. The outer protrusion 93 may be arranged in a region between the free end 89 and the base 90 along the insertion direction I.

Each outer protrusion 93 may have a convex cross section seen in the direction of the rotational axis R. The outer protrusions 93 are intended for interacting with trigger elements 61 of the frame module 3. The trigger elements 61 are indicated in Fig. 7 by the dashed line. Just by way of example, trigger elements 61 are indicated in a position in which they would interact with the outer protrusions 93 during removal of the interface module 5 from the frame module 3. As in the embodiment described with respect to Figs. 1 to 5, upon insertion and/or removal of the interface module 5 into or from a frame module 3, the trigger elements 61 are arranged in the module insertion path 57.

When the trigger elements 61 collide with the outer protrusions 93, the pusher members 85 will be deflected towards each other crossing a movement of the moveable coding elements 19 from a coding position C into the neutral position N.

In the mounting section 27, the moveable coding elements 19 of the second embodiment are provided with a plurality of recesses 95 on each side opposite to the longitudinal axis L. The interface module 5 is, on each inner wall 55, provided with a nose 97 which is formed complementary to the recesses 95.

The recesses 95 and the noses 97 on each side of the moveable coding element 19 form a form fit arrangement 99 which is formed as ratchet arrangement 99. The ratchet arrangement 99 is adapted to keep the moveable coding element 19 in the coding position C or the neutral position N. The ratchet arrangement 99 may be adapted for maintaining the position of the moveable coding element 19 as long as a force on the moveable coding element 19 does not exceed a predefined value.

The arrangement 99 may be adapted such that the moveable coding elements 19 are only moved during insertion of the interface module 5 into a frame module 3 or removal thereof and/or during insertion of a cartridge member 9 in the case that the moveable coding elements 19 are in the neutral position N prior to insertion of the cartridge member 9.

### Reference Signs

- 1: module arrangement
- 3: frame module
- 5: interchangeable interface module
- 7: interface receptacle
- 9: cartridge member
- 11: cartridge receptacle
- 12: modular field device connection unit
- 13: field device connection element
- 15: conductor
- 17: electric contact
- 19: moveable coding element
- 21: coding section
- 23: resetting section
- 25: housing
- 27: mounting section
- 29: free end of the movable coding element in the coding section
- 31: stop surface of the movable coding element
- 33: free end of the movable coding element in the resetting section
- 35: recess
- 37: arm
- 39: proximal sloped surface
- 41: distal sloped surface
- 43: extension
- 44: longitudinal direction of extension
- 45: resetting mechanism
- 47: unmoveable coding element
- 49: inclined surface
- 51: free end of the unmoveable coding element
- 53: stop surface of the unmoveable coding element
- 55: inner wall of the interface module
- 57: module insertion path
- 59: insertion path of the moveable coding element
- 61: trigger element
- 63: pair of trigger elements
- 65: guiding surface
- 67: guiding surface
- 69: width
- 71: distance between trigger elements
- 73: pin
- 75: through holes
- 77: ends of the pin
- 79: opening in interface module
- 81: thickness of the moveable coding element
- 83: gap
- 85: pusher member
- 86: insertion path of pusher member
- 87: protrusion
- 89: free end
- 91: base
- 93: outer protrusion
- 95: recess
- 97: nose
- 99: form fit arrangement
- D: depth direction
- I: insertion direction
- L: longitudinal axis
- R: axis of rotation
- W: width direction

## Claims

1. Module arrangement (1) for a modular field device connection unit (12), the arrangement comprising a frame module (3) with at least one interface receptacle (7) for receiving at least one interchangeable interface module (5), and at least one interface module (5), which is insertable into the at least one interface receptacle (7) along a module insertion path (57), wherein the at least one interface module (5) is provided with at least one cartridge receptacle (11) for receiving at least one cartridge member (9), and wherein the at least one interface module (5) is provided with at least one movable coding element (19), which is moveable from a neutral position (N) into at least one coding position (C) by insertion of a cartridge member (9) into the cartridge receptacle (11), **characterized in that** the at least one module arrangement (1) is provided with at least one resetting mechanism (45) for resetting the at least one movable coding element (19) into the neutral position (N) by insertion of the at least one interface module (5) into the at least one interface receptacle (7) and/or removal out of it, respectively, the resetting mechanism (45) comprising at least one trigger element (61), the trigger element (61) at least partially protruding into the at least one module insertion path (57).

2. Module arrangement (1) according to claim 1, **characterized in that** the at least one trigger element (61) partially protrudes into an insertion path (59) of the at least one movable coding element (19), the insertion path of the at least one movable coding element (19) being part of the module insertion path (57).

3. Module arrangement (1) according to claim 1 or 2, **characterized in that** the at least one resetting mechanism (45) comprises at least one pair (63) of trigger elements (61), the two trigger elements (61) of the at least one pair (63) being arranged opposite each other across the module insertion path (57).

4. Module arrangement (1) according to any of claims 1 to 3, **characterized in that** the at least one trigger element (61) is arranged on the frame module (3) and comprises at least one guiding surface (65, 67) for the at least one movable coding element (19), the at least one guiding surface (65, 67) being inclined with respect to a module insertion direction (I).

5. Module arrangement (1) according to any of claims 1 to 4, **characterized in that** the at least one interface module (5) is provided with at least one deflectable pusher member (85), and the frame module (3) is provided with at least one trigger element (61), the trigger element (61) protruding into an insertion path (86) of the at least one pusher member (85).

6. Module arrangement (1) according to claim 5, **characterized in that** the at least one pusher member (85) is elastically deflectable towards at least one movable coding element (19).

7. Module arrangement (1) according to any of claims 1 to 6, **characterized in that** the neutral position (N) and the at least one coding position (C) are stable positions (C, N) of the at least one movable coding element (19) with respect to the remaining interface module (5).

8. Module arrangement (1) according to claim 7, **characterized in that** the at least one movable coding element (19) is kept in at least one position (C, N) by frictional force.

9. Module arrangement (1) according to claim 7 or 8, **characterized in that** the at least one movable coding element (19) is kept in at least one position (C, N) by at least one form fit arrangement (99).

10. Module arrangement (1) according to any of claims 1 to 9, **characterized in that** at least one movable coding element (19) comprises at least one coding section (21) for interaction with at least one complementary coding element (47) of the cartridge member (9), and at least one resetting section (23) for interacting with the at least one trigger element (61).

11. Module arrangement (1) according to claim 10, **characterized in that** the at least one resetting mechanism (45) comprises at least one extension (43) on the at least one movable coding element (19), the extension (43) providing the at least one resetting section (23).

12. Module arrangement (1) according to claim 11, **characterized in that** the at least one extension (43) is provided with at least one arm (37) for interacting with the at least one trigger element (61), the at least one arm (37) extending basically perpendicular to a longitudinal direction (44) of the extension (43).

13. Modular field device connection unit (12) comprising at least one module arrangement (1) according to any of claims 1 to 12.

14. Modular field device connection unit (12) according to claim 13, **characterized in that** the modular field device connection unit further comprises at least one cartridge member (9) with at least one unmovable coding element (47) with at least one sloped surface (49) which is adapted to move at least one movable coding element (19) of the at least one interface module (5) from its neutral position (N) into at least one coding position (C) by inserting the at least one cartridge member (9) into the at least one interface module (5).

15. Method for coding and resetting the coding of at least one interface module (5) of a modular field device connection unit, wherein
- at least one movable coding element (19) is moved from a neutral position (N) into at least one coding position (C) by inserting a cartridge member (9) into the at least one interface module (5) along a module insertion path (57), and wherein
- the cartridge member (9) is removed from the at least one interface module (5),
**characterized in that**
by insertion of the at least one interface module (5) into at least one interface receptacle (7) of a frame module (3) of the modular field device connection unit and/or removal of the at least one interface module (5) thereof, the at least one movable coding element (19) interacts with at least one resetting mechanism (45) of the at least one frame module (3), the at least one resetting mechanism (45) resets the at least one movable coding element (19) from the at least one coding position (C) to the neutral position (N) with at least one trigger element (61) which protrudes into the module insertion path (57).

## Patentansprüche

1. Modulanordnung (1) für eine modulare Feldgerät-Anschlusseinheit (12), wobei die Anordnung ein Rahmen-Modul (3) mit wenigstens einer Schnittstellen-Aufnahme (7) zum Aufnehmen wenigstens eines austauschbaren Schnittstellen-Moduls (5), sowie wenigstens ein Schnittstellen-Modul (5) umfasst, das in die wenigstens eine Schnittstellen-Aufnahme (7) entlang eines Modul-Einführungsweges (57) eingeführt werden kann, wobei das wenigstens eine Schnittstellen-Modul (5) mit wenigstens einer Kassetten-Aufnahme (11) zum Aufnehmen wenigstens eines Kassetten-Teils (9) versehen ist, und das wenigstens eine Schnittstellen-Modul (5) mit wenigstens einem beweglichen Codier-Element (19) versehen ist, das durch Einführung eines Kassetten-Teils (9) in die Kassetten-Aufnahme (11) von einer Neutral-Position (N) in wenigstens eine Codier-Position (C) bewegt werden kann, **dadurch gekennzeichnet, dass** die wenigstens eine Modulanordnung (1) mit wenigstens einem Rückstell-Mechanismus (45) zum Rückstellen des wenigstens einen beweglichen Codier-Elementes (19) in die Neutral-Position (N) durch Einführung des wenigstens einen Schnittstellen-Moduls (5) in die wenigstens eine Schnittstellen-Aufnahme (7) und/oder Herausnehmen aus dieser versehen ist, wobei der Rückstell-Mechanismus (45) wenigstens ein Auslöse-Element (61) umfasst und das Auslöse-Element (61) wenigstens teilweise in den wenigstens einen Modul-Einführungsweg (57) hineinragt.

2. Modulanordnung (1) nach Anspruch 1, **dadurch gekennzeichnet, dass** das wenigstens eine Auslöse-Element (61) teilweise in einen Einführungsweg (59) des wenigstens einen beweglichen Codier-Elementes (19) hinein vorsteht, wobei der Einführungsweg des wenigstens einen beweglichen Codier-Elementes (19) Teil des Modul-Einführungsweges (57) ist.

3. Modulanordnung (1) nach Anspruch 1 oder 2, **dadurch gekennzeichnet, dass** der wenigstens eine Rückstell-Mechanismus (45) wenigstens ein Paar (63) von Auslöse-Elementen (61) umfasst, wobei die zwei Auslöse-Elemente (61) des wenigstens einen Paars (63) quer zu dem Modul-Einführungsweg (57) einander gegenüberliegend angeordnet sind.

4. Modulanordnung (1) nach einem der Ansprüche 1 bis 3, **dadurch gekennzeichnet, dass** das wenigstens eine Auslöse-Element (61) an dem Rahmen-Modul (3) angeordnet ist und wenigstens eine Führungsfläche (65, 67) für das wenigstens eine bewegliche Codier-Element (19) aufweist, wobei die wenigstens eine Führungsfläche (65, 67) in Bezug auf eine Modul-Einführungsrichtung (I) geneigt ist.

5. Modulanordnung (1) nach einem der Ansprüche 1 bis 4, **dadurch gekennzeichnet, dass** das wenigstens eine Schnittstellen-Modul (5) mit wenigstens einem biegbaren Schiebe-Element (85) versehen ist und das Rahmen-Modul (3) mit wenigstens einem Auslöse-Element (61) versehen ist, wobei das Auslöse-Element (61) in einen Einführungsweg (86) des wenigstens einen Schiebe-Elementes (85) hinein vorsteht.

6. Modulanordnung (1) nach Anspruch 5, **dadurch gekennzeichnet, dass** das wenigstens eine Schiebe-Element (85) elastisch auf wenigstens ein bewegliches Codier-Element (19) zu gebogen werden kann.

7. Modulanordnung (1) nach einem der Ansprüche 1 bis 6, **dadurch gekennzeichnet, dass** die Neutral-Position (N) und die wenigstens eine Codier-Position (C) stabile Positionen (C, N) des wenigstens einen beweglichen Codier-Elementes (19) in Bezug auf das übrige Schnittstellen-Modul (5) sind.

8. Modulanordnung (1) nach Anspruch 7, **dadurch gekennzeichnet, dass** das wenigstens eine bewegliche Codier-Element (19) durch Reibungskraft in wenigstens einer Position (C, N) gehalten wird.

9. Modulanordnung (1) nach Anspruch 7 oder 8, **dadurch gekennzeichnet, dass** das wenigstens eine bewegliche Codier-Element (19) durch wenigstens eine Formschluss-Anordnung (99) in wenigstens einer Position (C, N) gehalten wird.

10. Modulanordnung (1) nach einem der Ansprüche 1 bis 9, **dadurch gekennzeichnet, dass** wenigstens ein bewegliches Codier-Element (19) wenigstens einen Codier-Abschnitt (21) zum Zusammenwirken mit wenigstens einem komplementären Codier-Element (47) des Kassetten-Teils (9) und wenigstens einen Rückstell-Abschnitt (23) zum Zusammenwirken mit dem wenigstens einen Auslöse-Element (61) umfasst.

11. Modulanordnung (1) nach Anspruch 10, **dadurch gekennzeichnet, dass** der wenigstens eine Rückstell-Mechanismus (45) wenigstens eine Verlängerung (43) an dem wenigstens einen beweglichen Codier-Element (19) umfasst, wobei die Verlängerung (43) den wenigstens einen Rückstell-Abschnitt (23) bildet.

12. Modulanordnung (1) nach Anspruch 11, **dadurch gekennzeichnet, dass** die wenigstens eine Verlängerung (43) mit wenigstens einem Arm (37) zum Zusammenwirken mit dem wenigstens einen Auslöse-Element (61) versehen ist, wobei sich der wenigstens eine Arm (37) im Wesentlichen senkrecht zu einer Längsrichtung (44) der Verlängerung (43) erstreckt.

13. Modulare Feldgerät-Anschlusseinheit (12), die wenigstens eine Modulanordnung (1) nach einem der Ansprüche 1 bis 12 umfasst.

14. Modulare Feldgerät-Anschlusseinheit (12) nach Anspruch 13, **dadurch gekennzeichnet, dass** die modulare Feldgerät-Anschlusseinheit des Weiteren wenigstens ein Kassetten-Teil (9) mit wenigstens einem unbeweglichen Codier-Element (47) mit wenigstens einer schrägen Fläche (49) umfasst, das zum Bewegen wenigstens eines beweglichen Codier-Elementes (19) des wenigstens einen Schnittstellen-Moduls (5) von seiner Neutral-Position (N) in wenigstens eine Codier-Position (C) durch Einführen des wenigstens einen Kassetten-Teils (9) in das wenigstens eine Schnittstellen-Modul (5) eingerichtet ist.

15. Verfahren zum Codieren und Rückstellen der Codierung wenigstens eines Schnittstellen-Moduls (5) einer modularen Feldgerät-Anschlusseinheit, wobei
- wenigstens ein bewegliches Codier-Element (19) von einer Neutral-Position (N) in wenigstens eine Codier-Position (C) bewegt wird, indem ein Kassetten-Teil (9) entlang eines Modul-Einführungsweges (57) in das wenigstens eine Schnittstellen-Modul (5) eingeführt wird, und wobei
- das Kassetten-Teil (9) von dem wenigstens einen Schnittstellen-Modul (5) entfernt wird,
**dadurch gekennzeichnet, dass**
durch Einführung des wenigstens einen Schnittstellen-Moduls (5) in wenigstens eine Schnittstellen-Aufnahme (7) eines Rahmen-Moduls (3) der modularen Feldgerät-Anschlusseinheit und/oder Entfernung des wenigstens einen Schnittstellen-Moduls (5) derselben das wenigstens eine bewegliche Codier-Element (19) mit wenigstens einem Rückstell-Mechanismus (45) des wenigstens einen Rahmen-Moduls (3) zusammenwirkt, der wenigstens eine Rückstell-Mechanismus (45) das wenigstens eine bewegliche Codier-Element (19) aus der wenigstens einen Codier-Position (C) in die Neutral-Position (N) mit wenigstens einem Auslöse-Element (61) zurückstellt, das in den Modul-Einführungsweg (57) hinein vorsteht.

## Revendications

1. Agencement de module (1) pour une unité de connexion de dispositif de terrain modulaire (12), l'agencement comprenant un module de châssis (3) avec au moins une prise d'interface (7) pour recevoir au moins un module d'interface interchangeable (5), et au moins un module d'interface (5) qui peut être inséré dans ladite au moins une prise d'interface (7) selon un chemin d'insertion de module (57), dans lequel ledit au moins un module d'interface (5) est pourvu d'au moins une prise de cartouche (11) pour recevoir au moins un élément de cartouche (9), et dans lequel ledit au moins un module d'interface (5) est pourvu d'au moins un élément de codage mobile (19), qui est mobile d'une position neutre (N) à au moins une position de codage (C) par insertion d'un élément de cartouche (9) dans la prise de cartouche (11), **caractérisé en ce que** ledit au moins un agencement de module (1) est pourvu d'au moins un mécanisme de réinitialisation (45) pour réinitialiser ledit au moins un élément de codage mobile (19) dans la position neutre (N) par insertion dudit au moins un module d'interface (5) dans ladite au moins une prise d'interface (7) et/ou par extraction hors de celle-ci, respectivement, le mécanisme de réinitialisation (45) comprenant au moins un élément déclencheur (61), l'élément déclencheur (61) ressortant au moins partiellement dans ledit au moins un chemin d'insertion de module (57).

2. Agencement de module (1) selon la revendication 1, **caractérisé en ce que** ledit au moins un élément déclencheur (61) ressort partiellement dans le chemin d'insertion (59) dudit au moins un élément de codage mobile (19), le chemin d'insertion dudit au moins un élément de codage mobile (19) faisant partie du chemin d'insertion de module (57).

3. Agencement de module (1) selon la revendication 1 ou 2, **caractérisé en ce que** ledit au moins un mécanisme de réinitialisation (45) comprend au moins une paire (63) d'éléments déclencheurs (61), les deux éléments déclencheurs (61) de ladite au moins une paire (63) étant agencés de façon opposée de part et d'autre du chemin d'insertion de module (57).

4. Agencement de module (1) selon l'une quelconque des revendications 1 à 3, **caractérisé en ce qu'**au moins un élément déclencheur (61) est agencé sur le module de châssis (3) et comprend au moins une surface de guidage (65, 67) pour ledit au moins un élément de codage mobile (19), ladite au moins une surface de guidage (65, 67) étant inclinée par rapport à une direction d'insertion de module (I) .

5. Agencement de module (1) selon l'une quelconque des revendications 1 à 4, **caractérisé en ce que** ledit au moins un module d'interface (5) est pourvu d'au moins un élément poussoir flexible (85), et le module de châssis (3) est pourvu d'au moins un élément déclencheur (61), l'élément déclencheur (61) ressortant dans un chemin d'insertion (86) dudit au moins un élément poussoir (85).

6. Agencement de module (1) selon la revendication 5, **caractérisé en ce que** ledit au moins un élément poussoir (85) est flexible élastiquement vers ledit au moins un élément de codage mobile (19).

7. Agencement de module (1) selon l'une quelconque des revendications 1 à 6, **caractérisé en ce que** la position neutre (N) et ladite au moins une position de codage (C) sont des positions stables (C, N) dudit au moins un élément de codage mobile (19) par rapport au module d'interface restant (5).

8. Agencement de module (1) selon la revendication 7, **caractérisé en ce que** ledit au moins un élément de codage mobile (19) est maintenu dans au moins une position (C, N) par une force de friction.

9. Agencement de module (1) selon la revendication 7 ou 8, **caractérisé en ce qu'**au moins un élément de codage mobile (19) est maintenu dans au moins une position (C, N) par au moins un agencement par verrouillage de forme (99).

10. Agencement de module (1) selon l'une quelconque des revendications 1 à 9, **caractérisé en ce qu'**au moins un élément de codage mobile (19) comprend au moins une section de codage (21) pour une interaction avec au moins un élément de codage complémentaire (47) de l'élément de cartouche (9), et au moins une section de réinitialisation (23) pour interagir avec ledit au moins un élément déclencheur (61).

11. Agencement de module (1) selon la revendication 10, **caractérisé en ce que** ledit au moins un mécanisme de réinitialisation (45) comprend au moins une extension (43) sur ledit au moins un élément de codage mobile (19), l'extension (43) fournissant ladite au moins une section de réinitialisation (23).

12. Agencement de module (1) selon la revendication 11, **caractérisé en ce que** ladite au moins une extension (43) est pourvue d'au moins un bras (37) pour interagir avec ledit au moins un élément déclencheur (61), ledit au moins un bras (37) s'étendant de manière fondamentalement perpendiculaire à une direction longitudinale (44) de l'extension (43).

13. Unité de connexion de dispositif de terrain modulaire (12) comprenant au moins un agencement de module (1) selon l'une quelconque des revendications 1 à 12.

14. Unité de connexion de dispositif de terrain modulaire (12) selon la revendication 13, **caractérisé en ce que** l'unité de connexion de dispositif de terrain modulaire comprend en outre au moins un élément de cartouche (9) avec au moins un élément de codage inamovible (47) présentant au moins une surface inclinée (49) qui est adaptée pour déplacer au moins un élément de codage mobile (19) dudit au moins un module d'interface (5) de sa position neutre (N) à au moins une position de codage (C) en insérant ledit au moins un élément de cartouche (9) dans ledit au moins un module d'interface (5).

15. Procédé de codage et de réinitialisation du codage d'au moins un module d'interface (5) d'une unité de connexion de dispositif de terrain modulaire, dans lequel
- au moins un élément de codage mobile (19) est déplacé d'une position neutre (N) à au moins une position de codage (C) en insérant un élément de cartouche (9) dans ledit au moins un module d'interface (5) selon un chemin d'insertion de module (57), et dans lequel
- l'élément de cartouche (9) est extrait dudit au moins un module d'interface (5),
**caractérisé**
**en ce que**, par l'insertion dudit au moins un module d'interface (5) dans au moins une prise d'interface (7) d'un module de châssis (3) de l'unité de connexion de dispositif de terrain modulaire et/ou par l'extraction dudit au moins un module d'interface (5) de ladite prise, ledit au moins un élément de codage mobile (19) interagit avec au moins un mécanisme de réinitialisation (45) dudit au moins un module de châssis (3), et ledit au moins un mécanisme de réinitialisation (45) réinitialise ledit au moins un élément de codage mobile (19) de ladite au moins une position de codage (C) à la position neutre (N) avec au moins un élément déclencheur (61) qui ressort dans le chemin d'insertion de module (57).
